Europäisches Patentamt

European Patent Office

Office européen des brevets

(19)

(11) EP 0 729 397 B2

(12) NEW EUROPEAN PATENT SPECIFICATION

(45) Date of publication and mention
of the opposition decision:
**19.09.2001 Bulletin 2001/38**

(45) Mention of the grant of the patent:
**10.06.1998 Bulletin 1998/24**

(21) Application number: **95902622.0**

(22) Date of filing: **16.11.1994**

(51) Int Cl.⁷: **B23K 1/20**, B23K 35/38

(86) International application number:
**PCT/US94/13371**

(87) International publication number:
**WO 95/13896 (26.05.1995 Gazette 1995/22)**

(54) **FLUXLESS SOLDERING PRETREATING SYSTEM AND METHOD USING FLUORINE-CONTAINING PLASMA**

VORBEHANDLUNGSSYSTEM ZUM FLUSSMITTELFREIEN LÖTEN UND VERFAHREN UNTER VERWENDUNG EINES FLUORHALTIGEN PLASMAS

SYSTEME DE PRETRAITEMENT DE BRASAGE SANS FLUX ET PROCEDE DANS LEQUEL DU PLASMA CONTENANT DU FLUOR EST UTILISE

(84) Designated Contracting States:
**AT BE CH DE DK ES FR GB GR IE IT LI LU MC NL PT SE**

(30) Priority: **19.11.1993 US 155020**
**15.11.1994 US 339770**

(43) Date of publication of application:
**04.09.1996 Bulletin 1996/36**

(73) Proprietor: **MCNC**
**Research Triangle Park,**
**North Carolina 27709 (US)**

(72) Inventors:
• **BOBBIO, Stephen, M.**
**Wake Forest, NC 27587 (US)**
• **KOOPMAN, Nicholas, George**
**Raleigh, NC 27615 (US)**
• **NANGALIA, Sundeep**
**Raleigh, NC 27606 (US)**

(74) Representative: **Warren, Keith Stanley**
**BARON & WARREN**
**18 South End**
**Kensington**
**London W8 5BU (GB)**

(56) References cited:
**EP-A- 0 427 020          DE-A- 3 442 538**
**US-A- 4 921 157**

• **F&M FEINWERKTECHNIK & MESSTECHNIK, vol.101, no.7/8, August 1993 pages 308 - 312, XP000387212 LIEDKE 'Wellenlöten ohne Flussmittel'**
• **ELECTRONIC PACKAGING & PRODUCTION, vol.32, no.6, June 1992 page 11, XP000279076 CRUM 'MCNC, army develop fluxless soldering process'**

**Description**

The present invention relates to systems and methods for soldering, and more particularly to fluxless soldering methods and systems.

In fabricating electronic systems, integrated circuits ("chips") or other electrical devices are mounted on printed wiring boards, or other substrates. The contact between the chip and substrate must have physical, chemical and electrical integrity and stability. Copper is particularly useful as a layer in microelectronic devices, because of its good conductivity properties.

In one technique for physically and electrically connecting microelectronic devices, metal pads are fabricated on an exposed surface of a substrate. These metal pads are often formed with a top layer of solder, i.e., a low melting point alloy, usually of the lead-tin type, used for joining metals at temperatures about 230°C. The solder pads are brought into contact with a metal structural element that will be wet with liquid solder when heat is applied to join the solder and the metal pad and thereby form the electrical connection. Other techniques use a solder preform which is placed between the substrate and device. Yet other techniques use solder bumps which are applied to the device or to the substrate.

Typically, soldering processes include three basic steps: (1) pre-cleaning and deoxidation of surface oxides; (2) solder reflow and/or reflow joining; and (3) post-soldering cleaning. Different flux materials are used in the pre-cleaning step to prepare the surfaces for the soldering step by removal of contaminants and metal oxides from the solder surface. For example, activated fluxes, such as zinc, ammonium chloride, mineral acid-containing materials, and the like, are typically used in "coarse" soldering applications, i.e., repairing coarse wiring in motors or houses. The solder joining step can occur only after the oxide coating is removed because the high melting point oxides will prevent wetting of the two surfaces to be joined by reflow of solder. The third step, post-soldering cleaning, removes flux residue remaining after the reflow.

Highly acidic fluxes are used for the soldering of aluminum layers. Aluminum has a tenacious oxide layer which is chemically very inert and difficult to remove. Thus, mild rosin fluxes are ineffective with aluminum, and special fluxes containing acid compounds which are highly corrosive, such as inorganic acids in a cadmium fluoroborate vehicle, must be used. Fluxes used with aluminum can also contain metal chlorides, fluorides, and ammonium compounds.

Because of the gross corrosive nature of these fluxes, and the high attack rates on metals in microelectronic assemblies, such fluxes cannot be used in microelectronics. For microelectronic devices, the standard practice is to reduce the acid activity of the flux to a mildly activated or non-activated grade in an attempt to minimize the adverse effects of the flux on the components. Typical soldering processes for copper layers in microelectronic applications use rosins which form a very mild organic acid when melted at the soldering temperature but which are relatively inert at room temperature.

Although corrosion and other risks can be minimized in copper soldering applications using mild flux agents, flux is necessary to keep the solder from oxidizing, allow it to flow and wet the parts being soldered. In addition, with the shrinking size of all electronic components and bonding pads, the rapidly growing use of surface mount technology, and the increasing demand for flip-chip device bonding, the post reflow cleaning of flux residues is becoming increasingly difficult. The small gaps between assembled parts, and solidification cavities in mixed soldered joints are very resistant to penetration by cleaning liquids. Inefficient post-soldering cleaning can reduce the long term reliability of the whole assembly. Further, there can be other problems associated with non-activated or mildly activated flux processes, such as higher defect levels and high rework costs. Optoelectronic devices are also very sensitive to flux residues due to absorption and bending of the optical signals.

A fluxless soldering process, particularly for soldering microelectronic devices including a copper layer, therefore can have several advantages. A dry or fluxless soldering process can replace the pre-cleaning step and totally eliminate the post-soldering cleaning step. Fluxless soldering has also gained increasing importance in recent years due to concerns for the environmental effect of common cleaning agents, such as chloroflurocarbons.

Various attempts at fluxless soldering have been made but with limited success. Some fluxless processes have used halogenated gases. For example, P. Moskowitz et al., J.Vac.Sci.Tech. **4**, (May/June 1986) describe a dry soldering process for solder reflow and bonding of lead/tin solder. The process uses halogen-containing gases to reduce the surface oxide to enable solder reflow at temperatures above the solder-melting point. The activation energy needed for the oxide reduction by these gases is lowered by use of a catalyst, platinum mesh, in a vacuum chamber. Yet the temperature needed for successful reflow bonding is 300°C, well above typical soldering temperatures for most electronic applications of about 220°C. Thus, this process can damage the components, the substrate, and generate defects due to thermal mismatch between different materials.

IBM Technical Disclosure Bulletin **27** (Apr. 1985) describes the use of halogenated gases in an inert carrier gas at elevated temperatures to produce a reduction of solder oxide by the reactive gas and to allow solder reflow. Again, for the more common low temperature applications, thermal damage may result.

P. Moskowitz et al., J.Vac.Sci.Tech. **3** (May/June 1985) describe a laser-assisted fluxless soldering technique for solder reflow. This technique uses laser radiation to excite an otherwise nonreactive gas in the presence of preheated solder surface. This technique requires direct access of the laser beam to the solder surface, thus limiting the applications as well as resulting in a low throughput process.

A major advance in fluxless soldering is described in U.S. Patent No. 4,921,157 to Dishon and coinventor Bobbio entitled "*Fluxless Soldering Process*" and assigned to the assignee of the present invention. The Dishon et al. patent discloses the use of fluorine-containing plasma excitation on solder to eliminate or reduce the need for fluxing agents. However, in order to obtain full advantage of fluxless soldering processes which use fluorine-containing plasma on a sample, there is a need for an efficient fluxless soldering sample pretreating system which can efficiently apply a fluorine-containing plasma to a sample.

German Patent No. 3,442,538 discloses a method of soldering semiconductor elements wherein a semiconductor element having an aluminum layer is subjected to a fluorine-containing plasma. The treated aluminum surface is then contacted with a soft solder. Process conditions include treating the aluminum layer with a fluorine-containing plasma for at least 1 hour in a vacuum at a temperature of about 147°C to 397°C. Alternative process conditions use a standard soldering iron, presumably in the presence of flux, to remove oxides. Further, as with several of the processes described above, the temperatures used are well above typical soldering temperatures for most electronic applications, and can result in damage to the components.

The types of fluxes and flux conditions used for aluminum are very different than those used for copper soldering. Because of the nature of the tarnish finish of copper, mild rosin fluxes can be used. Copper forms only a mild galvanic cell with solder due to their close electromotive potentials (0.13 vs. -.34 for tin and copper, respectively). Thus the corrosion risk for soldered copper is very low when mild rosin fluxes are used. Further, the attack of the copper and solder and other fine metal features of the microelectronic circuit is low enough to be acceptable in most soldering processes. See H. Manko, Solders and Soldering (McGraw Hill New York 1992), pp. 380-381; 156-158.

In contrast, aluminum has a tenacious surface oxide layer which is difficult to remove and which is chemically very inert. Special fluxes are used for aluminum which contain highly corrosive acid compounds, such as inorganic acids in a cadmium fluoroborate vehicle. Fluxes used with aluminum can also contain metal chlorides, fluorides, and ammonium compounds. The flux mechanism usually involves aluminum attack, forming aluminum chlorides which are gaseous at the soldering temperature and help disperse the oxide layer of the aluminum surface. Because of the gross corrosive nature of the fluxes, and the high attack rate on metals in microelectronic assemblies, these fluxes cannot be used for copper or in microelectronic applications. The particular combination of lead tin solder and aluminum is also very bad from a galvanic standpoint in that the potential difference between the solder and the aluminum (1.53 v) exceeds the tolerable range and fast deterioration of the joint occurs under humid conditions. See H. Manko, Solders and Soldering (McGraw Hill New York 1992), pp. 373-375.

Thus fluxes and conditions for the soldering of aluminum are very different than for the soldering of copper. H. Manko, Solders and Soldering (McGraw Hill New York 1992), pp. 160-161. What works for one will not work for the other, and vice versa. This is also true of controlled atmosphere soldering which makes use of reducing gases such as hydrogen or carbon monoxide, or organic acid gases such as formic acid or acetic acids. These have been demonstrated to have some applicability to copper but are woefully inadequate on aluminum. Thus it is not expected that a technique to solder aluminum would work with copper. In fact, one skilled in the art would expect just the opposite. See C. Mackay, Flux Reactions and Solderability in Solder Joint Reliability, J. Lau Editor (Van Nostrand Reinhold, New York, 1991), pp. 73-80.

It is an object of the present invention to provide an improved fluxless soldering method and system.

According to the present invention, there are provided a method of soldering as defined in claim 1, and a fluxless soldering system as defined in claim 11.

Typically, a flux agent is required to effectively solder a copper surface because of the presence of oxide compounds on the surface of the copper layer. These oxides must be removed before reflow/wetting can occur. In the present invention, the surface of the copper layer is pretreated prior to soldering under conditions sufficient to convert at least some of the copper surface oxides to a compound which permits solder reflow without the use of flux agents.

Specifically, in the method embodying the invention, an exposed surface of a copper layer is pre-treated via a plasma treatment using fluorinated gases, such as $SF_6$, $CF_4$, and the like. The fluorinated gas is excited to form a fluorine-containing plasma, and the copper layer is exposed to the gases downstream from the fluorine-containing plasma. The gases from the fluorine-containing plasma are believed to act upon surface oxide compounds found on the surface of the copper layer, converting the oxide compounds to fluorine-containing compounds. After the pretreatment step, solder is placed onto the surface of the copper layer and reflowed.

The process conditions of the present invention are flexible and can be selected to optimize solder reflow. For example, the pretreatment of the copper layer can be conducted at low temperatures, i.e., from about 20°C to 24°C. Alternatively, the copper layer can be pre-treated at elevated temperatures up to about 120°C. In addition, plasma treatment times can be short, i.e., about 2 to 30 minutes. In a preferred embodiment of the invention, the exposed surface of the copper layer is exposed to a fluorine-containing plasma at a pressure from 53 to 106 Pa (400 mTorr to 800 mTorr) and at a temperature from 20°C to 120°C for a period of 15 minutes. The exposing step results in a fluorine/oxygen ratio on the copper surface of about 2/1 to about 8/1.

The pre-treatment of the copper layer in a downstream fluorine-containing plasma does not have to be coupled to the reflow process. After the pre-treatment step, copper samples can be stored in air, for up to one week, before the reflow/join operation is performed. Alternatively, the pretreated copper layer can be stored in an inert ambient, such as nitrogen, for up to 2 weeks, before the reflow/join operation is performed. Thus existing soldering tools can be used.

After the pre-treatment step, solder is placed onto the surface of the copper layer and reflowed. In contrast to prior techniques for soldering copper layers, particularly in microelectronic applications, rosin fluxes are not required. This results in reduction or elimination of problems associated with the use of flux agents, such as disposal of chemical reagents, post reflow cleaning of flux residues, higher defect levels, high rework costs, and the like. In addition, problems associated with soldering metal layers which have a chemically very inert and difficult to remove oxide layer, such as aluminum, are absent, and harsh, corrosive flux agents required therefore are not necessary.

The present invention is advantageous over techniques requiring a flux agent not only for the above reasons. The present invention also allows for flexibility in selection of reflow conditions which are effective with the pretreated copper layer. Further, reflow can be conducted using existing equipment. For example, because the pre-treatment step converts oxide compounds present on the surface of the copper layer to oxyfluorides, which break up when the solder melts, reflow and joining can occur in an oxidizing (air) ambient. Soldering can also be conducted under an inert ambient, i.e., nitrogen, but providing a reducing ambient or soldering is not required. Similarly, reflow can occur at atmospheric pressure; a vacuum is not required. Thus, soldering can be conveniently conducted under conditions where a reducing atmosphere or a vacuum cannot be easily provided.

In addition, high temperatures are not required for successful reflow. The temperature can be adjusted to typical soldering temperatures for most electronic applications, for example about 200°C to about 220°C for eutectic PbSn solders. This is particularly advantageous when working with a microelectronic device because of the delicate nature of the substrate and other components. Thus damage to the components and the substrate can be eliminated or greatly reduced.

The process embodying the present invention thus eliminates flux, flux dispensing, flux cleaning, flux cleaning solvents, and disposal of the spent chemicals. The process is flexible and reflow can occur even in an oxidizing or inert atmosphere, at low temperatures, and at atmospheric pressure using existing equipment. High throughput, reliable soldering process is provided, which does not damage the components to be soldered, nor the environment.

A fluxless soldering sample pretreating system embodying the invention includes a sample chamber having an opening therein and also having a sample holder in the sample chamber for holding the sample. A sample chamber extension extends outwardly from the opening in the sample chamber to define a passageway from the sample chamber extension, through the opening, and into the sample chamber. A fluorine-containing gas is supplied into the sample chamber extension.

The pretreating system also includes an energy source, preferably a microwave energy source, for supplying energy to the sample chamber extension. The microwave energy source may be a microwave oven having a microwave oven cavity which surrounds the sample chamber extension. The microwave oven produces microwave energy in the sample chamber extension to form a plasma therein and dissociate the fluorine-containing gas into atomic fluorine. Gas permeable plasma containing means is included in the passageway to block the plasma from traversing the passageway from the sample chamber extension into the sample chamber, while allowing the atomic fluorine to traverse the passageway from the sample chamber extension into the sample chamber.

Preferably, the gas permeable plasma containing means is a perforated aluminum plate which extends transversely across the passageway. Also, in order to improve the uniformity of the exposure of the sample to fluorine-containing plasma, the plasma chamber preferably includes a second microwave oven, the cavity of which surrounds a second sample chamber extension, a second fluorine-containing gas supply into the second sample chamber extension, and second gas permeable plasma containing means in the second passageway. Efficient pretreatment of fluxless soldering samples is provided thereby.

Reference will now be made to the accompanying drawings, in which:

Figure 1 schematically illustrates a side view of an apparatus for pre-treating a copper layer in a fluorine-containing plasma in accordance with the present invention;

Figure 2 is a flowchart illustrating operation of a process of the invention of pretreating a copper layer and fluxless soldering thereof;

Figure 3 is a wetting index chart illustrating the degree of spreading of eutectic solder on treated and untreated copper layers;

Figure 4 is a scanning electron microphotograph (SEM) illustrating spreading of an untreated solder disk on untreated copper;

Figure 5 is a scanning electron microphotograph illustrating spreading of an untreated solder disk on a treated copper layer in accordance with the present invention; and

Figure 6 is a graph illustrating the relationship of fluorine to oxygen ratio on the surface of a treated layer to the percent effectiveness of the pre-treatment.

The present invention will be now described more fully hereinafter with reference to the accompanying drawings, in which a preferred embodiment of the invention is shown. This invention can, however, be embodied in many different forms and should not be construed as limited to the embodiment set forth herein; rather, applicants provide this embodiment so that this disclosure will be thorough and complete, and will fully convey the scope of the invention to those skilled in the art. Like characters refer to like elements throughout.

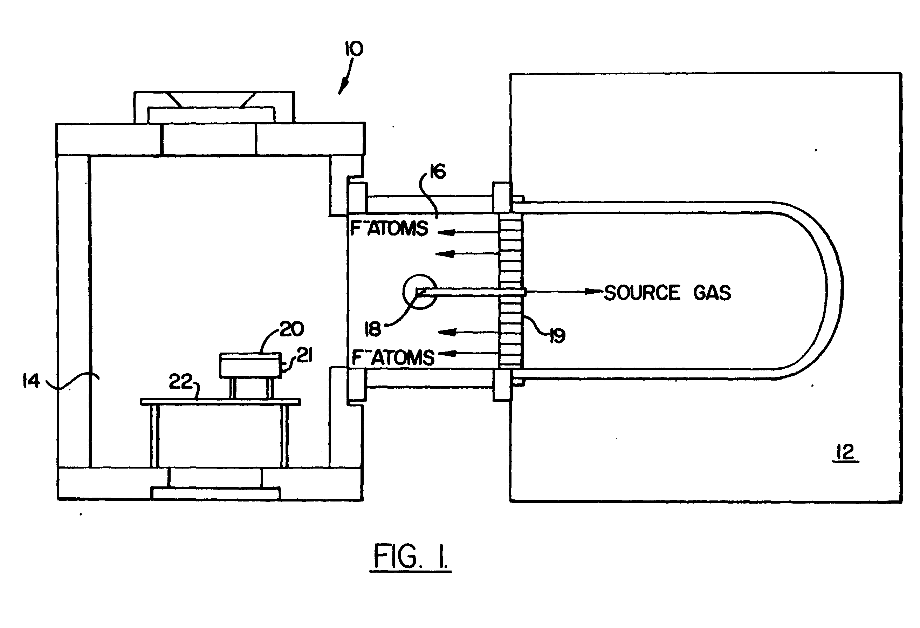

Figure 1 schematically illustrates a side view of a preferred copper layer pre-treatment apparatus **10** used in accordance with the present invention. As illustrated, pre-treatment apparatus **10** includes a plasma energy generating chamber **12**, a sample treatment chamber **14**, and a passageway **16** connecting chambers **12** and **14**.

A fluorine-containing gas, such as $SF_6$, $CF_4$ and the like, is provided from gas supply line **18** into the plasma energy generating chamber **12**. Here, energy is generated sufficient to disassociate the fluorine-containing gas to form atomic fluorine. The plasma energy may be generated using any of the techniques known in the art for creating a fluorine-containing plasma. In one advantageous embodiment of the invention, the plasma generating energy is provided from a microwave source, such as a microwave oven.

The disassociated fluorine atoms diffuse from the plasma energy generating chamber **12** through passageway **16** and into the sample reaction chamber **14**. Preferably, a perforated aluminum plate **19** is provided between plasma energy generating chamber **12** and passageway **16**. The aluminum plate contains the active plasma generation to within chamber **12** so the samples are not exposed to the plasma generating energies or temperatures. This also allows free flow of gases, so fluorine atoms can enter the sample chamber and react with the surface oxides on the sample. In addition, aluminum reacts very slowly with fluorine and passivates so fluorine atom concentration in the sample chamber **14** is maximized and very little fluorine is absorbed by the aluminum.

A copper sample which is to be exposed to the fluorine-containing gases is provided within sample chamber **14**. As illustrated, the copper sample can be, for example, a copper layer **20** provided on a substrate **21** and having an exposed copper surface. Typically, the copper will be a microelectronic substrate, integrated circuit, or other such device, having solderable pads with an outer copper surface. As will be appreciated by the skilled artisan, the exposed copper surface includes copper oxide compounds.

Advantageously, the copper sample is placed on a sample stage **22**, which can be thermally coupled to a heating means (not shown) for selectively adjusting the temperature of the stage, and thus the copper sample, prior to and during the pre-treatment step.

The surface of the copper layer **20** is pre-treated by exposing the copper surface to the gases from the fluorine-containing plasma. The plasma pre-treating process conditions are selected to provide the desired degree of exposure of the copper surface to fluorine atoms. Conditions are selected so that the copper surface is exposed to fluorine atoms for a time sufficient so as to convert a least some of the copper oxide compounds present on the surface thereof to fluorine-containing compounds, i.e., copper oxyfluoride compounds, as explained in more detail below. Stated differently, the copper surface is exposed to the fluorine-containing plasma gases until sufficient fluorine-containing compounds form on the copper surface to permit subsequent wetting of solder to occur.

Preferably, the pre-treating exposing step is conducted to provide a fluorine/oxygen ratio on the copper surface of about 2/1 to about 8/1. Although the exact mechanism of the fluorine/oxygen interaction is not understood, tests have demonstrated that the pretreatment of the copper layer in accordance with the invention is especially effective when the fluorine/oxygen ratio on the surface of the copper layer falls within this range. The exact ratio will vary according to the amount of copper surface oxides present prior to pretreatment, the time of pretreatment, the distance of the sample from the fluorine atom source, and the like.

The temperature of the copper layer can be varied during exposure to the fluorine atoms. For example, the pretreatment of the copper layer can take place at room temperature (about 20 to 24°C). Alternatively, pretreatment may occur at elevated temperatures, i.e., the copper layer can be heated to a temperature up to about 120°C or higher. Preferably, the plasma process is short in duration, i.e., about 2 to 30 minutes, and plasma pressures are from about 53 to 106 Pa (400 to 800 mTorr). Power level, gas flow, gas mixture and other typical plasma process conditions can vary according to the reactor configuration and the nature of the assembly to be treated.

Advantageously, a second plasma energy generating chamber (not illustrated) is coupled to the sample chamber **14** opposite plasma energy chamber **12**, to provide a more thorough and equal distribution of the fluorine atoms onto the copper surface.

Although applicants do not wish to be bound by any theory, it is believed that exposing the copper layer, particularly copper oxide compounds on the surface of the copper layer, to fluorine atoms results in a reaction wherein copper oxyfluorides are formed on the surface of the copper layer. This effectively transforms surface oxides which prevent solder reflow or wetting of surfaces to be solder joined, and thus allows for effective soldering to take place without the need for fluxing agents, high temperatures, and the like. It is further believed that the activation energy needed for converting the oxides is supplied by excited fluorine radicals in the plasma which diffuse and hit the surface oxide, resulting in the formation of the fluoride compounds on the copper layer surface.

Following exposure of the copper layer **20** to the fluorine-containing plasma, the substrate **21** containing the copper layer is removed from the treatment chamber **14**. Solder is then placed on the copper surface. The solder can be of any appropriate soldering material, such as tin, lead-tin, and lead-tin based alloys. Advantageously, the solder is an eutectic 63% tin, 37% lead material having a melting point of 183°C.

The solder is reflowed to form either a solder bump or to reflow and join a second surface. The second surface may be a component or another solder bump. Alternatively the copper surface can be dipped in a molten solder bath or wave and the copper surface "tinned" with the appropriate solder alloy. As noted with regard to plasma forming and exposing conditions above, the process conditions for reflow can be selected to optimize reflow. Thus reflow can be performed in an oxidizing atmosphere, i.e., air, or alternatively under an inert atmosphere, such as nitrogen. Similarly, reflow can take place under atmospheric pressure or under vacuum pressure conditions, although the latter is not necessary.

In addition, reflow can take place at temperatures just above the melting point of the solder. For example, using a 63/37 weight percent tin/lead material, reflow takes place just above the melting point of the solder of 183°C at a temperature of about 200°C to 220°C.

The present invention is subject to numerous variations. For example, the plasma pre-treatment step and the reflow process may occur simultaneously and/or the second surface may be brought in contact with the solder during reflow. In addition, copper samples can be pre-treated in the sample pre-treatment chamber, removed and stored for up to one week under an oxidizing ambient, i.e., air, and then transported for successful joining in a different facility. Alternatively, pre-treated copper samples can be stored for up two weeks in an inert ambient, i.e., nitrogen, and then subjected to reflow conditions.

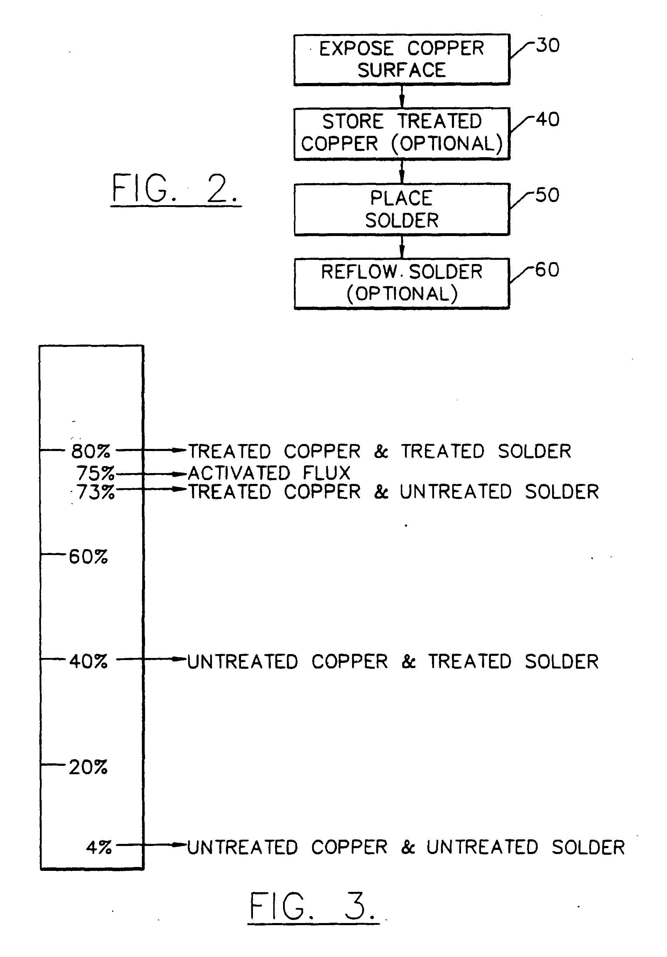

Referring now to Figure 2, a preferred process for pretreating and fluxless soldering of a copper layer in accordance with the present invention is illustrated. A substrate which includes a copper layer having an exposed copper surface is provided. As illustrated in Block **30** of Figure 2, the copper surface thereof is exposed to a fluorine-containing gas in a downstream microwave plasma. The plasma pre-treating process conditions of Block **30** are selected to provide the desired degree of exposure of the copper surface to fluorine atoms. As noted above, advantageously, conditions are selected so that the copper surface is exposed to fluorine atoms for a time sufficient so as to convert at least some of the copper oxide compounds present on the surface thereof to fluorine-containing compounds, i.e., copper oxyfluoride compounds. Preferably, the pre-treating exposing step is conducted to provide a fluorine/oxygen ratio on the copper surface of about 2/1 to about 8/1.

The exposure of the copper layer can take place at room temperature (about 20 to 24°C). Alternatively, elevated temperatures can be used, i.e., the copper layer can be heated to a temperature up to about 120°C or higher. Preferably, the plasma process is short in duration, i.e., about 15 to 30 minutes, and plasma pressures are from about 53 to 106 Pa (400 to 800 mTorr).

As indicated in Block **40**, following exposure of the copper surface to a fluorine-containing plasma, the copper sample can optionally stored for up to one week under an oxidizing ambient, i.e., air. Alternatively, pre-treated copper samples can be stored for up two weeks in an inert ambient, i.e., nitrogen.

Solder is then placed on the copper surface as indicated in Block **50**. In Block **60**, following solder placement the solder is reflowed. Reflow can be performed in an oxidizing atmosphere, i.e., air, or alternatively under an inert atmosphere, such as nitrogen. Similarly, reflow can take place under atmospheric pressure or under vacuum pressure conditions, although the latter is not necessary. In addition, reflow can take place at temperatures just above the melting point of the solder. For example, using a 63/37 weight percent tin/lead material, reflow takes place just above the melting point of the solder of 183°C at a temperature of about 200°C to 220°C. As also described above, the reflow step can occur as part of a joining step.

The following examples are provided to illustrate a process of the invention but are not to be construed as limitations on the invention.

EXAMPLE 1

Comparison of Solder Spreading on Treated and Untreated Copper Surfaces

A matrix of experiments was run to characterize the spreading of 1 mm solder disks on bare copper coupons cut out of sheet copper. All samples pretreated in accordance with the present invention were exposed to a fluorine-containing plasma under conditions of 106 Pa (800 mTorr) for 15 minutes.

The testing was designed to determine the spreading index when the copper surfaces were pretreated in accordance with the present invention. Of interest were (a) spreading of an untreated solder disk on treated copper; (b) spreading of a treated solder disk on untreated copper; and (c) spreading of a treated solder disk on treated copper.

The effect of heat during the pre-treatment was also investigated. Untreated samples and samples reflowed with flux were used as controls for determining the effectiveness of the treatment. Spreading testing was carried out in a hot stage using a slow ramp (about two minutes) under a nitrogen cover.

Rapid reflow in air was also tested. A copper coupon with a solder disk on it was dropped on a hot stage maintained at 235°C to simulate a rapid reflow (dip) conditions. The heat-up time was on the order of a few seconds (less than five seconds).

Spreading was measured by the formula:

$$S = (l-h/D) \times 100;$$

where S is the spreading index, h is the solder height and D is the theoretical diameter of a perfect sphere of the 1 mm disk's solder volume. The best value of S is 100 and the worst zero.

The results obtained showed good wetting of copper by eutectic solder using the process of the present invention. Figure 3 graphically illustrates the resultant wetting index of the samples. The scale is from 0 to 100. As seen from Figure 3, the best spreading index was obtained when both the copper and the solder disk were given the optimal treatment (S approximately 80%), which was better than when activated flux was used (S approximately 75%). The spreading of untreated solder on treated copper (S approximately 73%) was also dose to the results obtained for activated flux. The spreading of solder on copper coupons in air with rapid reflow was about 69%. Temperature of pre-treatment had a marginal effect on spreading.

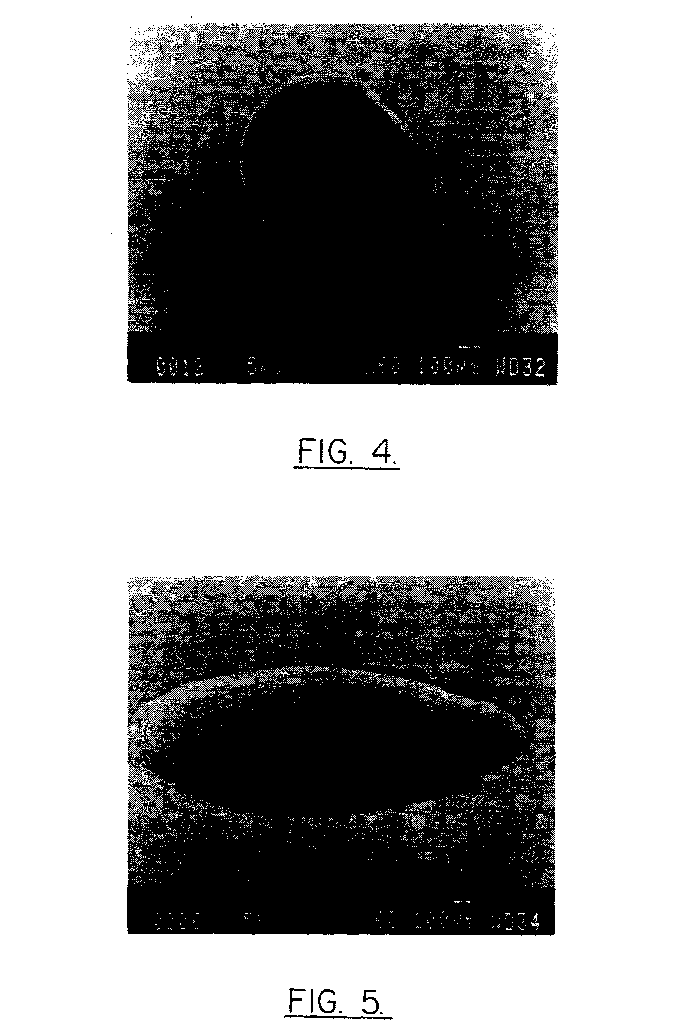

Scanning electron microphotographs of untreated and treated copper are shown in Figures 4 and 5, respectively. In Figure 4, the solder and copper were untreated. The solder is still in the form of a ball and there is almost no spreading. In Figure 5, the solder disk was untreated and the copper surface was treated. The solder is seen to spread out and wet the copper, and the spreading index increased from 4% to 73%. This illustrates that good solder spreading and wetting can be obtained when the copper surface alone is pretreated in accordance with the invention.

EXAMPLE 2

Rapid Reflow in Air (Dip) of Printed Circuit Boards

Rapid reflow was also tested on circuit boards with copper serpentine lines to cover a wider variety of samples. Standard test patterns were treated in accordance with the present invention. These patterns had bare copper serpentine pattern with 0,635 mm (25 mil) lines and 1,27 mm (50 mil) space. The size of the boards were 5 cm by 5 cm (2" by 2") square. The test patterns with bare copper were cleaned in alconox soap solution followed by a rinse in hot water and isopropyl alcohol before the treatment. Plasma conditions as described in Example 1 above were used for treating the samples.

Treated samples were dipped halfway in a pot of eutectic solder. The pieces were held there for 10 seconds before pulling them out. All the reflows were done in air. Visual inspection was the only means used to characterize the effectiveness. The solder wet the copper completely forming a smooth uniform covering on the lines. The solder did not bridge any of the lines on the sample. On the other hand, the rapid reflow (dip) results of the control samples (untreated boards) were quite different. Solder is seen sticking at some points on the lines but the amount of solder is very minimal. No portion of the line is fully covered by solder. The performance of the control sample was very poor.

The test results of Example 2 illustrate the effectiveness of pretreating the surface of a copper sample prior to reflow. When the copper surface is pretreated in accordance with the invention, solder reflows easily without requiring the use of fluxing agents. In contrast, when the copper surface is not pretreated, and reflow is attempted without the use of a fluxing agent, reflow and wetting of the Solder is very poor.

EXAMPLE 3

Surface Characterization of Printed Circuit Boards

As noted above, it is believed that during plasma treatment of a copper sample, copper oxide compounds present on the surface of the copper layer are converted to copper oxyfluorocompounds, which allows fluxless soldering and wetting. One technique for judging the effectiveness of the process of the invention is in terms of fluorine to oxygen (F/O) ratio. This gives a truer picture than individual fluorine or oxygen concentrations, since the samples having different oxide thicknesses might pick up different amounts of fluorine.

Wavelength dispersive x-ray (WDX) was used in this study on the bare copper printed circuit boards. WDX gives the concentrations of fluorine and oxygen on the surface of the samples. Once the ratio of the oxygen and fluorine contents were obtained, they were compared with the master curve generated using 1 mm eutectic solder disk samples.

Printed circuit boards with bare copper were cleaned in alconox soap solution followed by a rinse in hot water and isopropyl alcohol. Pieces measuring 2,54 cm X 5,08 cm (1 inch x 2 inch) were cut from the board and pretreated at room temperature and at 120°C. A small piece was cut for surface analysis and the remaining piece was dipped in a pot of eutectic solder in air at 235°C. The piece was held there for 10 seconds and then pulled out.

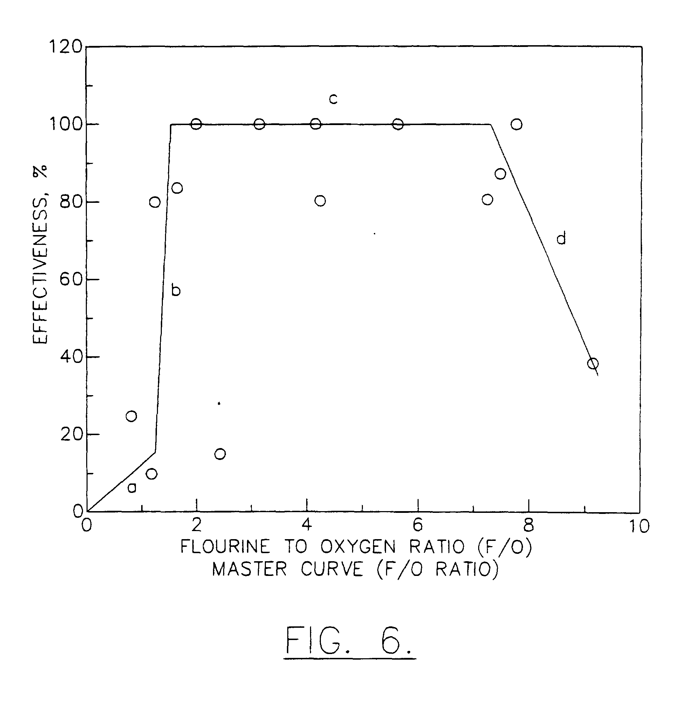

Results for both the room temperature treatment and the 120°C treatment were good. The F/O ratio for room temperature treatment was 2.77 and increased to 8.63 at 120°C. This increase in the ratio is not due to a significant increase in fluorine pickup but the decrease in oxygen concentration on the surface. Table 1 below gives the complete list of the treatment conditions and the results of the surface analysis. Almost all the ratios in Table 1 fall on the master curve as shown in Figure 6. As seen from Figure 6, the best range of operation to give 100% effectiveness is in the range of 2 and 8, i.e., a fluorine/oxygen ratio on the copper surface of about 2/1 to about 8/1. This is true for eutectic solder disks. For other samples, such as printed circuit boards which come in contact with untreated solder during the joining operation, a higher F/O ratio might be better.

Table 1

| Concentrations of Oxygen, Fluorine and the Ratio of Fluorine to Oxygen | | | | |
|---|---|---|---|---|
| | Treatment conditions | Fluorine wt% | Oxygen wt% | F/O ratio |
| 1 | Alconox clean Cu printed circuit boards | - | 1.12 | - |
| 2 | Clean Copper PCB pretreated at room temperature | 5.31 | 1.92 | 2.77 |
| 3 | Clean Copper PCB pretreated at 120°C | 5.89 | 0.68 | 8.63 |

In the drawings and specification, there have been disclosed typical preferred embodiments of the invention, and although specific terms are used, they are used in a generic and descriptive sense only and not for purpose of limitation, the scope of the invention being set forth in the following claims.

**Claims**

1. A method of soldering a copper layer having a surface oxide layer without the need for fluxing agents, comprising the steps of:

   exposing a copper layer having a surface oxide layer to a fluorine-containing plasma to convert at least a portion of the surface oxide layer to fluorine-containing compounds, wherein said exposing is performed until sufficient fluorine-containing compounds form on said copper surface to permit solder wetting to occur; and placing solder on the fluorine-containing converted surface oxide layer.

2. The method of Claim 1 wherein said exposing step results in a fluorine/oxygen ratio on said copper surface of about 2/1 to about 8/1.

3. The method of Claim 1 wherein the following step is performed between said exposing step and said placing step:
   storing the exposed copper layer (20) in an air ambient for a period of up to about one week.

4. The method of Claim 1 wherein the following step is performed between said exposing step and said placing step:
   storing the exposed copper layer (20) in an inert ambient for a period of up to about two weeks.

5. The method of Claim 1 further comprising the step of reflowing said solder on the surface of said copper layer (20) after said placing step.

6. The method of Claim 5 wherein said reflowing step occurs at atmospheric pressure.

7. The method Claim 5 wherein said reflowing step occurs in an oxidizing ambient.

8. The method of Claim 5 wherein said reflowing step occurs in an inert ambient.

9. The method of Claim 5 wherein said reflowing step comprises placing said solder in contact with a second surface to thereby solder join together said copper surface and said second surface without the need for post-soldering cleaning.

10. The method of Claim 1 wherein said exposing step comprises the step of:
exposing said copper layer having said surface oxide layer to a fluorine-containing plasma at a pressure from 53 to 106 Pa (400 mTorr to 800 mTorr) and at a temperature from 20°C to 120°C for a period of 15 to 30 minutes.

11. A fluxless soldering sample pretreating system, comprising:

a sample chamber (14) having an opening therein;
sample holding means (22) in said sample chamber for holding a sample;
a sample chamber extension, extending outwardly from said opening in said sample chamber (14), to define a passageway (16) from said sample chamber extension through said opening and into said sample chamber (14);
fluorine-containing gas supplying means (18), for supplying fluorine-containing gas into said sample chamber extension;
means for producing energy in said sample chamber extension to form a plasma therein and dissociate the fluorine-containing gas into atomic fluorine; and
gas permeable plasma containing means (19) in said passageway, for blocking the plasma from traversing said passageway (16) from said sample chamber extension into said sample chamber (14), while allowing the atomic fluorine to traverse said passageway (16) from said sample chamber extension into said sample chamber (14), to thereby perform fluorine-containing plasma excitation on said sample.

12. A pretreating system according to Claim 11 wherein said sample chamber (14) further includes a second opening therein, said pretreating system further comprising:

a second sample chamber extension, extending outwardly from said second opening in said sample chamber, to define a second passageway from said second sample chamber extension through said second opening and into said sample chamber;
said energy producing means further producing energy in said second sample chamber extension;
said fluorine-containing gas supplying means further supplying fluorine-containing gas into said second sample chamber extension; and
second gas permeable plasma containing means in said second passageway, for blocking plasma from traversing said second passageway from said second sample chamber extension to said sample chamber, while allowing fluorine radicals to traverse said second passageway from said second sample chamber extension to said sample chamber.

13. A pretreating system according to Claim 11 further comprising means for heating said sample holding means to thereby heat the sample.

14. A pretreating system according to Claim 11 wherein said fluorine-containing gas supplying means (18) is a fluorine-containing gas supply line having an outlet in said sample chamber extension.

15. A pretreating system according to Claim 14 wherein said fluorine-containing gas supply line (18) extends from said sample chamber (14), through said gas permeable plasma containing means (19), and into said sample chamber extension.

16. A pretreating system according to Claim 11 wherein said energy producing means comprises microwave energy producing means, for producing microwave energy in said sample chamber extension.

17. A pretreating system according to Claim 16 wherein said microwave energy producing means comprises a microwave oven including a microwave oven cavity, said microwave oven cavity surrounding said sample chamber extension.

18. A pretreating system according to Claim 11 wherein said gas permeable plasma containing means comprises a perforated aluminum plate (19) extending transversely across said passageway (16), for blocking the plasma from traversing said passageway (16) from said sample chamber extension into said sample chamber (14), while allowing the atomic fluorine to traverse said passageway (16) from said sample chamber extension into said sample chamber (14), to thereby perform fluorine-containing plasma excitation on said sample.

**Patentansprüche**

1. Verfahren zum Löten einer Kupferschicht, die eine Oberflächenoxidschicht aufweist, ohne Notwendigkeit für Flussmittel, wobei das Verfahren die folgenden Schritte umfasst:

   Unterziehen einer Kupferschicht, die eine Oberflächenoxidschicht aufweist, der Einwirkung eines fluorhaltigen Plasmas, um wenigstens einen Teil der Oberflächenoxidschicht in fluorhaltige Verbindungen umzuwandeln, wobei die genannte Einwirkung so lange fortgesetzt wird, bis ausreichend fluorhaltige Verbindungen auf der genannten Kupferoberfläche entstanden sind, um eine Benetzung mit Lötmaterial zuzulassen; und
   Aufbringen von Lötmaterial auf die fluorhaltige umgewandelte Oberflächenoxidschicht.

2. Verfahren nach Anspruch 1, wobei der genannte Einwirkungsschritt ein Fluor/Sauerstoff-Verhältnis auf der genannten Kupferoberfläche von ungefähr 2:1 bis 8:1 zur Folge hat.

3. Verfahren nach Anspruch 1, wobei der folgende Schritt zwischen dem genannten Einwirkungsschritt und dem genannten Aufbringungsschritt ausgeführt wird:
   Lagern der behandelten Kupferschicht (20) in einer Luftumgebung für eine Zeitdauer von bis zu ungefähr einer Woche.

4. Verfahren nach Anspruch 1, wobei der folgende Schritt zwischen dem genannten Einwirkungsschritt und dem Aufbringungsschritt ausgeführt wird:
   Lagern der behandelten Kupferschicht (20) in einer inerten Umgebung für eine Zeitdauer von bis zu ungefähr zwei Wochen.

5. Verfahren nach Anspruch 1, das ferner den folgenden Schritt umfasst: Verfließenlassen des genannten Lötmaterials auf der Oberfläche der genannten Kupferschicht (20) nach dem genannten Aufbringungsschritt.

6. Verfahren nach Anspruch 5, wobei der genannte Verfließschritt bei Atmosphärendruck erfolgt.

7. Verfahren nach Anspruch 5, wobei der genannte Verfließschritt in einer oxidierenden Umgebung erfolgt.

8. Verfahren nach Anspruch 5, wobei der genannte Verfließschritt in einer inerten Umgebung erfolgt.

9. Verfahren nach Anspruch 5, wobei der genannte Verfließschritt das Aufbringen des genannten Lötmaterials in Kontakt mit einer zweiten Oberfläche umfasst, um so die genannte Kupferoberfläche und die genannte zweite Oberfläche miteinander zu verlöten, ohne eine Reinigung nach dem Verlöten erforderlich zu machen.

10. Verfahren nach Anspruch 1, wobei der genannte Einwirkungsschritt den folgenden Schritt umfasst:
    Unterziehen der genannten Kupferschicht, die die genannte Oberflächenoxidschicht aufweist, der Einwirkung eines fluorhaltigen Plasmas bei einem Druck von 53 bis 106 Pa (400 mTorr bis 800 mTorr) und bei einer Temperatur von 20°C bis 120°C für eine Zeitdauer von 15 bis 30 Minuten.

11. Vorbehandlungssystem für Proben zum flussmittelfreien Löten, das folgendes umfasst:

    eine Probenkammer (14) mit einer Öffnung darin;
    ein Probenhaltemittel (22) in der genannten Probenkammer zum Halten einer Probe;
    eine Probenkammererweiterung, die sich von der genannten Öffnung in der genannten Probenkammer (14) nach außen erstreckt, um einen Durchgang (16) von der genannten Probenkammererweiterung durch die genannte Öffnung und in die genannte Probenkammer (14) zu definieren;
    Zuführungsmittel (18) für fluorhaltiges Gas zum Einleiten von fluorhaltigem Gas in die genannte Probenkammererweiterung;
    ein Mittel zum Erzeugen von Energie in der genannten Probenkammererweiterung, um ein Plasma darin zu bilden und das fluorhaltige Gas in atomisches Fluor zu zerlegen; und
    ein gasdurchlässiges, Plasma zurückhaltendes Mittel (19) in dem genannten Durchgang, das den Durchtritt von Plasma durch den genannten Durchgang (16) von der genannten Probenkammererweiterung in die genannte Probenkammer (14) verhindert und gleichzeitig den Durchtritt des atomischen Fluors durch den genannten Durchgang (16) von der genannten Probenkammererweiterung in die genannte Probenkammer (14) zulässt, um so die Anregung der genannten Probe mit fluorhaltigem Plasma durchzuführen.

12. Vorbehandlungssystem nach Anspruch 11, wobei die genannte Probenkammer (14) ferner eine zweite Öffnung beinhaltet, wobei das genannte Vorbehandlungssystem ferner folgendes umfasst:

eine zweite Probenkammererweiterung, die sich von der genannten zweiten Öffnung in der genannten Probenkammer nach außen erstreckt, um einen zweiten Durchgang von der genannten zweiten Probenkammererweiterung durch die genannte zweite Öffnung und in die genannte Probenkammer zu definieren; wobei das genannte Energieerzeugungsmittel ferner Energie in der genannten zweiten Probenkammererweiterung erzeugt; wobei das genannte Zuführungsmittel für fluorhaltiges Gas ferner fluorhaltiges Gas in die genannte zweite Probenkammererweiterung leitet; und ein zweites gasdurchlässiges, Plasma zurückhaltendes Mittel in dem genannten zweiten Durchgang, um den Durchtritt von Plasma durch den genannten zweiten Durchgang von der genannten zweiten Probenkammererweiterung zu der genannten Probenkammer zu verhindern und gleichzeitig den Durchtritt von Fluorradikalen durch den genannten zweiten Durchgang von der genannten zweiten Probenkammererweiterung zu der genannten Probenkammer zuzulassen.

13. Vorbehandlungssystem nach Anspruch 11, das ferner ein Mittel zum Erhitzen des genannten Probenhaltemittels umfasst, um so die Probe zu erhitzen.

14. Vorbehandlungssystem nach Anspruch 13, wobei das genannte Zuführungsmittel (18) für fluorhaltiges Gas eine Zuführungsleitung für fluorhaltiges Gas ist, die einen Auslass in die Probenkammererweiterung aufweist.

15. Vorbehandlungssystem nach Anspruch 14, wobei die genannte Zuführungsleitung (18) für fluorhaltiges Gas von der genannten Probenkammer (14) durch das genannte gasdurchlässige, Plasma zurückhaltende Mittel (19) und in die genannte Probenkammererweiterung verläuft.

16. Vorbehandlungssystem nach Anspruch 11, wobei das genannte Energieerzeugungsmittel ein Mikrowellenenergie-Erzeugungsmittel umfasst, um Mikrowellenenergie in der genannten Probenkammererweiterung zu erzeugen.

17. Vorbehandlungssystem nach Anspruch 16, wobei das genannte Mikrowellenenergie-Erzeugungsmittel einen Mikrowellenofen umfasst, der einen Mikrowellenofenhohlraum beinhaltet, wobei der Mikrowellenofenhohlraum die genannte Probenkammererweiterung umgibt.

18. Vorbehandlungssystem nach Anspruch 11, wobei das genannte gasdurchlässige, Plasma zurückhaltende Mittel eine perforierte Aluminiumplatte (19) umfasst, die quer durch den Durchgang (16) verläuft, um zu verhindern, dass das Plasma durch den genannten Durchgang (16) von der genannten Probenkammererweiterung in die genannte Probenkammer (14) fließt, und um gleichzeitig den Durchtritt von atomischem Fluor durch den genannten Durchgang (16) von der genannten Probenkammererweiterung in die genannte Probenkammer (14) zuzulassen, um so die Anregung der Probe mit fluorhaltigem Plasma durchzuführen.

**Revendications**

1. Méthode de brasage d'une couche de cuivre ayant une couche d'oxyde de surface sans besoin d'agents de flux, comprenant les étapes:

d' exposition d'une couche de cuivre ayant une couche d'oxyde de surface à un plasma contenant du fluor pour convertir au moins une portion de la couche d'oxyde de surface en composés contenant du fluor, dans laquelle ladite exposition est réalisée jusqu'à ce que suffisamment de composés contenant du fluor se forment sur ladite surface de cuivre pour permettre la production d'un mouillage de la brasure ; et de placement de la brasure sur la couche d'oxyde de surface convertie et contenant du fluor.

2. Méthode selon la revendication 1, dans laquelle ladite étape d'exposition conduit à un rapport fluor/oxygène sur ladite surface de cuivre d'environ 2/1 à environ 8/1.

3. Méthode selon la revendication 1, dans laquelle l'étape suivante est réalisée entre ladite étape d'exposition et ladite étape de placement :

conservation de la couche de cuivre exposée (20) sous un air ambiant pendant une période allant jusqu'à environ une semaine.

4. Méthode selon la revendication 1, dans laquelle l'étape suivante est réalisée entre ladite étape d'exposition et ladite étape de placement :

conservation de la couche de cuivre exposée (20) sous une atmosphère inerte pendant une période allant jusqu'à environ deux semaines.

5. Méthode selon la revendication 1, comprenant en outre l'étape de refusion de ladite brasure sur la surface de ladite couche de cuivre (20) après ladite étape de placement.

6. Méthode selon la revendication 5, dans laquelle ladite étape de refusion se produit à pression atmosphérique.

7. Méthode selon la revendication 5, dans laquelle ladite étape de refusion se produit sous une atmosphère oxydante.

8. Méthode selon la revendication 5, dans laquelle ladite étape de refusion se produit sous une atmosphère inerte.

9. Méthode selon la revendication 5, dans laquelle ladite étape de refusion comprend le placement de ladite brasure en contact avec une deuxième surface pour relier ainsi par brasure ladite surface de cuivre et ladite deuxième surface ensemble sans besoin d'un nettoyage après brasure.

10. Méthode selon la revendication 1, dans laquelle ladite étape d'exposition comprend l'étape :

d'exposition de ladite couche de cuivre ayant ladite couche d'oxyde de surface à un plasma contenant du fluor à une pression de 53 à 106 Pa (400 mTorr à 800 mTorr) et à une température de 20°C à 120°C pendant une période de 15 à 30 minutes.

11. Système de pré-traitement d'échantillons de brasage sans flux, comprenant :

une chambre d'échantillon (14) ayant une ouverture dans celle-ci ;
un moyen de support d'échantillon (22) dans ladite chambre d'échantillon pour supporter un échantillon ;
une extension de chambre d'échantillon, s'étendant vers l'extérieur depuis ladite ouverture dans ladite chambre d'échantillon (14) pour définir un passage (16) depuis ladite extension de chambre d'échantillon à travers ladite ouverture et dans ladite chambre d'échantillon (14) ;
un moyen d'alimentation de gaz contenant du fluor (18), pour alimenter du gaz contenant du fluor dans ladite extension de chambre d'échantillon ;
un moyen de production d'énergie dans ladite extension de chambre d'échantillon pour y former un plasma et dissocier le gaz contenant du fluor en fluor atomique ; et
un moyen contenant du plasma perméable au gaz (19) dans ledit passage, pour empêcher le plasma de traverser ledit passage (16) depuis ladite extension de chambre d'échantillon dans ladite chambre d'échantillon (14), tout en permettant au fluor atomique de traverser ledit passage (16) depuis ladite extension de chambre d'échantillon dans ladite chambre d'échantillon (14), pour réaliser ainsi une excitation au plasma contenant du fluor sur ledit échantillon.

12. Système de pré-traitement selon la revendication 11, dans lequel ladite chambre d'échantillon (14) comprend en outre une deuxième ouverture dans celle-ci, ledit système de pré-traitement comprenant en outre :

une deuxième extension de chambre d'échantillon, s'étendant vers l'extérieur depuis ladite deuxième ouverture dans ladite chambre d'échantillon, pour définir un deuxième passage depuis ladite deuxième extension de chambre d'échantillon à travers ladite deuxième ouverture et dans ladite chambre d'échantillon ;
ledit moyen de production d'énergie produisant en outre de l'énergie dans ladite deuxième extension de chambre d'échantillon ;
ledit moyen d'alimentation de gaz contenant du fluor alimentant en outre du gaz contenant du fluor dans ladite deuxième extension de chambre d'échantillon ; et
un deuxième moyen contenant du plasma perméable au gaz dans ledit deuxième passage, pour empêcher du plasma de traverser ledit deuxième passage depuis ladite deuxième extension de chambre d'échantillon vers ladite chambre d'échantillon, tout en permettant à des radicaux de fluor de traverser ledit deuxième passage depuis ladite deuxième extension de chambre d'échantillon vers ladite chambre d'échantillon.

13. Système de pré-traitement selon la revendication 11, comprenant en outre un moyen de chauffage dudit moyen de support d'échantillon pour chauffer ainsi l'échantillon.

14. Système de pré-traitement selon la revendication 11, dans lequel ledit moyen d'alimentation de gaz contenant du fluor (18) est une ligne d'alimentation de gaz contenant du fluor ayant une sortie dans ladite extension de chambre d'échantillon.

15. Système de pré-traitement selon la revendication 14, dans lequel ladite ligne d'alimentation de gaz contenant du fluor (18) s'étend depuis ladite chambre d'échantillon (14) à travers ledit moyen contenant du plasma perméable au gaz (19) et dans ladite extension de chambre d'échantillon.

16. Système de pré-traitement selon la revendication 11, dans lequel ledit moyen de production d'énergie comprend un moyen de production d'énergie micro-onde, pour produire de l'énergie micro-onde dans ladite extension de chambre d'échantillon.

17. Système de pré-traitement selon la revendication 16, dans lequel ledit moyen de production d'énergie micro-onde comprend un four micro-onde comportant une cavité de four micro-onde, ladite cavité de four micro-onde entourant ladite extension de chambre d'échantillon.

18. Système de pré-traitement selon la revendication 11, dans lequel ledit moyen contenant du plasma perméable au gaz comprend une plaque d'aluminium perforée (19) s'étendant transversalement à travers ledit passage (16) pour empêcher le plasma de traverser ledit passage (16) depuis ladite extension de chambre d'échantillon dans ladite chambre d'échantillon (14), tout en permettant au fluor atomique de traverser ledit passage (16) depuis ladite extension de chambre d'échantillon dans ladite chambre d'échantillon (14) pour réaliser ainsi l'excitation au plasma contenant du fluor sur ledit échantillon.

FIG. I.

FIG. 2.

┌─────────────────────┐
│  EXPOSE COPPER      │─30
│     SURFACE         │
└─────────────────────┘
          │
          ▼
┌─────────────────────┐
│  STORE TREATED      │─40
│ COPPER (OPTIONAL)   │
└─────────────────────┘
          │
          ▼
┌─────────────────────┐
│      PLACE          │─50
│     SOLDER          │
└─────────────────────┘
          │
          ▼
┌─────────────────────┐
│  REFLOW SOLDER      │─60
│   (OPTIONAL)        │
└─────────────────────┘

80% ────────► TREATED COPPER & TREATED SOLDER
75% ────────► ACTIVATED FLUX
73% ────────► TREATED COPPER & UNTREATED SOLDER

60%

40% ────────► UNTREATED COPPER & TREATED SOLDER

20%

4% ─────────► UNTREATED COPPER & UNTREATED SOLDER

FIG. 3.

15

FIG. 4.

FIG. 5.

FIG. 6.